# FASCICULE DE BREVET EUROPEEN

(11) **EP 3 835 890 B1**
(45) Date de publication et mention de la délivrance du brevet: **15.06.2022**
(21) Numéro de dépôt: 19215910.1
(22) Date de dépôt: 13.12.2019
(51) Int. Cl.: G02F 1/1343, G04G 9/06, G04G 9/12, G04G 9/00

(54) **DISPOSITIF D'AFFICHAGE DIGITAL COMPRENANT DEUX CELLULES D'AFFICHAGE SUPERPOSEES**
DIGITALE ANZEIGEVORRICHTUNG, DIE ZWEI ÜBEREINANDER ANGEORDNETE ANZEIGEZELLEN UMFASST
DEVICE FOR DIGITAL DISPLAY COMPRISING TWO OVERLAPPING DISPLAY CELLS

(43) Date de publication de la demande: 16.06.2021
(73) Titulaire: The Swatch Group Research and Development Ltd, 2074 Marin (CH)
(72) Inventeur: BLANCKAERT, M. Nicolas, 2017 Boudry (CH); THIAULT, M. Jérôme, 2013 Colombier (CH); SAGARDOYBURU, Michel, 2000 Neuchâtel (CH); BARRON, Mme Cécile, 2035 Corcelles (CH)
(74) Mandataire: ICB SA

(56) Documents cités:
- EP-A1- 2 963 505
- EP-A1- 3 006 994
- CH-A2- 710 226

## Description

### Domaine technique de l'invention

La présente invention concerne un dispositif d'affichage digital comprenant deux cellules d'affichage superposées. Plus précisément, la présente invention concerne un dispositif d'affichage digital comprenant en combinaison une cellule d'affichage à cristal liquide transflective et une cellule d'affichage émissive. La présente invention concerne également une pièce d'horlogerie, en particulier une montre-bracelet, équipée d'un dispositif d'affichage digital du genre précisé ci-devant.

### Arrière-plan technologique de l'invention

La présente invention a en particulier pour objet de répondre à la demande de certains clients nostalgiques des premières montres électroniques apparues sur le marché au début des années 1970, en proposant à ceux-ci une montre électronique réalisée selon les standards actuels mais présentant l'aspect visuel de ces premières montres électroniques.

Les premières montres électroniques utilisaient un dispositif d'affichage digital dont les segments étaient formés par des diodes électroluminescentes également bien connues sous leur dénomination anglo-saxonne Light Emitting Diode ou LED. Ces dispositifs d'affichage digitaux étant de type émissif, leur consommation électrique était bien trop élevée pour qu'ils puissent être maintenus allumés en permanence. C'est pourquoi leur allumage se faisait à la demande du porteur de la montre, par pression sur un bouton-poussoir, ce qui permettait de faire apparaître fugitivement l'heure courante, la date, le défilement des secondes, voire le jour de la semaine. Les LED utilisées émettaient une couleur rouge car c'étaient les seules que l'on savait faire à l'époque.

Les segments qui composaient les dispositifs d'affichage digitaux des premières montres électroniques étaient de forme allongée et regroupaient plusieurs points d'émission lumineux sur un même substrat en silicium. Une telle solution était coûteuse en raison de la surface de silicium utilisée et n'est plus disponible commercialement de nos jours. Par ailleurs, utiliser des LED disponibles commercialement de nos jours est également compliqué car le conditionnement de ces LED de petites dimensions est trop volumineux pour que les points d'émission lumineux formés par ces LED soient aussi proches les uns des autres que sur la montre originelle.

EP 2 963 505 A1, EP 3 006 994 A1 et CH 710 226 A2 divulguent une montre munis d'un écran LCD transflectif et une couche OLED. Dans des conditions d'éclairage normales, la couche LCD est utilisée dans un état opaque pour afficher les informations d'heure, de date, etc. Dans des conditions de faible luminosité ou d'obscurité, la couche OLED est utilisée, la couche LCD étant transmissive dans cette condition.

Il existait donc sur le marché une forte demande pour une montre électronique dont l'aspect soit le même que celui des premières montres électroniques commercialisées à partir du début des années 1970, mais qui soit conçue au moyen de composants disponibles de nos jours.

### Résumé de l'invention

La présente invention a pour but de répondre à cette demande ainsi qu'à d'autres encore en procurant un dispositif d'affichage digital pour une pièce d'horlogerie, ce dispositif d'affichage digital étant réalisé avec les moyens techniques disponibles de nos jours et étant donc plus fiable et plus économique, mais présentant l'aspect visuel des dispositifs d'affichage qui équipaient les premières montres électroniques apparues au début des années 1970.

A cet effet, la présente invention concerne un dispositif d'affichage digital comprenant, du haut vers le bas, un premier filtre rouge, une cellule d'affichage à cristal liquide transflective, un second filtre rouge et une cellule d'affichage émissive, la cellule d'affichage à cristal liquide affichant des informations au moyen d'au moins un premier digit à sept segments, et la cellule d'affichage émissive comprenant une pluralité de points lumineux juxtaposés qui sont agencés de façon à afficher au moins un second digit à sept segments.

Selon des modes particuliers d'exécution de l'invention :
- la cellule d'affichage à cristal liquide transflective est une cellule d'affichage à cristal liquide nématique en hélice, également connue sous sa dénomination anglo-saxonne Twisted Nematic Liquid Crystal Display Device ou cellule TN, à laquelle sont associés un polariseur linéaire disposé au-dessus de la cellule d'affichage à cristal liquide nématique en hélice et un polariseur transflectif disposé en-dessous de la cellule d'affichage à cristal liquide nématique ;
- la cellule d'affichage émissive est une cellule d'affichage à diodes électroluminescentes organiques, également connue sous sa dénomination anglo-saxonne Organic Light-Emitting Diode, qui émet une lumière rouge ;
- le dispositif d'affichage digital comprend, de haut en bas et dans cet ordre :
   - le premier filtre rouge ;
   - le polariseur linéaire ;
   - la cellule d'affichage à cristal liquide nématique en hélice ;
   - le polariseur transflectif ;
   - le second filtre rouge ;
   - la cellule d'affichage à diodes électroluminescentes organiques ;
- le dispositif d'affichage digital comprend, de haut en bas et dans cet ordre :
   - le polariseur linéaire ;
   - le premier filtre rouge ;
   - la cellule d'affichage à cristal liquide nématique en hélice ;
   - 2. le polariseur transflectif ;
   - le second filtre rouge ;
   - la cellule d'affichage à diodes électroluminescentes organiques ;
- un capteur de lumière, placé sous la cellule d'affichage émissive, mesure l'intensité de l'éclairement ambiant, cette mesure de l'intensité de l'éclairement ambiant étant utilisée pour accommoder la luminosité de la cellule d'affichage émissive en fonction des conditions d'éclairement ambiant.

Grâce à ces caractéristiques, la présente invention procure un dispositif d'affichage digital permettant, avec des moyens disponibles de nos jours, de reproduire l'aspect des premiers dispositifs d'affichage digitaux apparus au début des années 1970. Ces premiers affichages digitaux se distinguaient notamment par leur couleur rouge qui s'expliquait par le fait qu'à l'époque, seules des diodes électroluminescentes de cette couleur étaient disponibles, et par la forme des caractères affichés qui se présentaient à la façon de digits à sept segments. En proposant un tel dispositif d'affichage digital, la présente invention a notamment pour but non seulement de répondre à la demande des amateurs de montres nostalgiques des premières montres électroniques qui ne parviennent plus à trouver sur le marché de la seconde main des montres originales de ce type en état de marche, et d'offrir à ces amateurs de montres des pièces d'horlogerie neuves qui ont le même aspect que les pièces d'horlogerie anciennes, mais dont le fonctionnement est beaucoup plus fiable grâce à l'emploi de composants modernes, mais aussi d'améliorer l'expérience d'utilisation en procurant un dispositif d'affichage digital affichant les informations en permanence.

Pour atteindre cet objectif, la présente invention enseigne de combiner une cellule d'affichage à cristal liquide transflective qui permet de lire les informations qu'elle affiche dans de bonnes conditions lorsque le porteur de la montre-bracelet dispose d'un bon éclairement ambiant fourni par le soleil ou par un éclairage artificiel, avec une cellule d'affichage émissive qui va afficher les informations de manière lisible lorsque le porteur de la montre-bracelet se trouve dans la pénombre ou l'obscurité. Pour parfaire la ressemblance du dispositif d'affichage digital selon l'invention avec les premiers dispositifs d'affichage digitaux commercialisés, les caractères affichés par la cellule d'affichage à cristal liquide transflective sont formés par des digits à sept segments. De même, les points d'émission lumineux fournis par la cellule d'affichage émissive sont agencés de façon à former des digits à sept segments. Enfin, on dispose un premier filtre rouge au-dessus de la cellule d'affichage à cristal liquide transflective afin de conférer aux caractères affichés par la cellule d'affichage à cristal liquide transflective la couleur rouge caractéristique des premiers dispositifs d'affichage digitaux commercialisés. Quant à la cellule d'affichage émissive, elle est conçue de façon que ses points d'émission lumineux émettent de la lumière rouge et peut en outre être combinée avec un second filtre rouge pour ajuster précisément l'aspect de la lumière rouge qu'elle émet à la couleur rouge qui est recherchée.

Grâce à ces dispositions, on obtient un dispositif d'affichage digital formé d'une cellule d'affichage à cristal liquide transflective et d'une cellule d'affichage émissive qui toutes deux sont capables d'afficher des informations dans la partie rouge du spectre de la lumière visible. Quand le porteur de la montre se trouve dans de bonnes conditions d'éclairement ambiant (lumière naturelle ou artificielle), il peut lire les informations qui lui sont fournies par la cellule d'affichage à cristal liquide transflective. Inversement, lorsque le porteur de la montre se trouve dans la pénombre ou l'obscurité, il lui suffira d'actionner un bouton-poussoir pour commander l'extinction de la cellule d'affichage à cristal liquide transflective et l'allumage de la cellule d'affichage émissive. Ainsi, même dans des conditions de luminosité faible ou nulle, le porteur de la montre pourra lire les informations affichées par le dispositif d'affichage digital selon l'invention dans des conditions optimales.

A la lecture de ce qui précède, on comprend qu'outre le fait que le dispositif d'affichage digital selon l'invention soit plus fiable et présente un prix de revient beaucoup plus avantageux que les premiers dispositifs d'affichage digitaux apparus sur les marchés au début des années 1970, le dispositif d'affichage digital selon l'invention est également beaucoup plus économe en énergie que ses lointains ancêtres.

En effet, dans le cas des premiers dispositifs d'affichage digitaux, ceux-ci ne présentaient que deux états distincts : un premier état éteint dans lequel ils se trouvaient la plupart du temps et dans lequel ils ne fournissaient aucune information, et un second état allumé dans lequel ils affichaient une information de manière fugace après pression du porteur de la montre sur un bouton-poussoir. Au contraire, dans le cas du dispositif d'affichage digital selon l'invention, la cellule d'affichage à cristal liquide transflective affiche une information en permanence tout en ne nuisant pas à l'autonomie de ce dispositif d'affichage digital.

Ceci est rendu possible par le fait que la consommation électrique d'une telle cellule d'affichage à cristal liquide transflective est très faible et n'affecte donc pas négativement les réserves d'énergie électrique de la montre-bracelet dans laquelle elle est montée. Par conséquent, par défaut, le porteur de la montre-bracelet dispose constamment de l'information affichée par la cellule d'affichage à cristal liquide transflective. S'il se trouve dans des conditions d'éclairement ambiant qui le permettent, le porteur peut donc lire cette information. Au contraire, si le porteur de la montre-bracelet se trouve dans la pénombre ou l'obscurité, il activera la cellule d'affichage émissive, ce qui lui permettra, dans ce cas aussi, de lire les informations affichées par le dispositif d'affichage digital selon l'invention dans de bonnes conditions. Par conséquent, alors que les premiers dispositifs d'affichage digitaux mis sur le marché ne pouvaient commuter qu'entre un état où ils étaient aveugles et un état où ils affichaient une information de manière très fugitive, le dispositif d'affichage digital selon l'invention peut être commuté entre un état par défaut dans lequel il affiche constamment une information au moyen de sa cellule d'affichage à cristal liquide transflective, et un état dans lequel cette information est affichée par la cellule d'affichage émissive. Par conséquent, grâce à ces caractéristiques, le dispositif d'affichage digital selon l'invention fournit l'information souhaitée au porteur de la montre en permanence et non pas seulement de manière fugace après pression du porteur de la montre sur un bouton-poussoir. En outre, que l'information soit affichée par la cellule d'affichage à cristal liquide transflective ou par la cellule d'affichage émissive, celle-ci présente la même couleur rouge et est agencée à la façon de digits formés de sept segments.

Enfin, selon un autre mode particulier d'exécution de l'invention, on équipe le présent dispositif d'affichage digital d'un capteur de lumière, préférentiellement disposé sous la cellule d'affichage émissive, ce capteur de lumière ayant pour fonction de mesurer l'intensité de l'éclairement ambiant, mesure qui est ensuite utilisée pour adapter la luminosité de la cellule d'affichage émissive en fonction des conditions d'éclairement ambiant. Ainsi, lorsque l'intensité de l'éclairement ambiant est faible, l'intensité de l'affichage fourni par la cellule d'affichage émissive sera volontairement maintenue basse afin de ne pas éblouir le porteur de la montre lorsqu'il appuie sur le bouton-poussoir pour consulter sa montre et, inversement, lorsque la mesure effectuée par le capteur de lumière indiquera un niveau d'éclairement ambiant élevé, l'intensité de la lumière fournie par la cellule d'affichage émissive sera augmentée afin de garantir la lisibilité des informations fournies par cette dernière.

Grâce à ces caractéristiques, la présente invention procure un dispositif d'affichage digital permettant, avec des moyens disponibles de nos jours, de reproduire l'aspect des premiers dispositifs d'affichage digitaux apparus au début des années 1970. Par rapport à leurs prédécesseurs, les dispositifs d'affichage selon l'invention sont plus fiables et leur consommation électrique est plus faible alors qu'ils sont capables d'afficher des informations en permanence, là où les dispositifs d'affichage digitaux de l'art antérieur n'affichaient les informations que de manière fugace, à la demande du porteur de la montre.

### Brève description des figures

D'autres caractéristiques et avantages de la présente invention ressortiront plus clairement de la description détaillée qui suit d'un exemple d'un dispositif d'affichage digital selon l'invention, cet exemple étant donné à titre purement illustratif et non limitatif seulement en liaison avec le dessin annexé sur lequel :
- la figure 1 est une vue schématique en coupe d'un dispositif d'affichage digital conforme à l'invention comprenant une cellule d'affichage à cristal liquide transflective disposée au-dessus d'une cellule d'affichage émissive, avec un premier filtre rouge disposé au-dessus de la cellule d'affichage à cristal liquide transflective et un second filtre rouge disposé entre la cellule d'affichage à cristal liquide transflective et la cellule d'affichage émissive ;
- la figure 2 est une vue schématique qui illustre l'agencement des segments d'affichage des informations de la cellule d'affichage à cristal liquide transflective sous forme de digits à 7 segments, et
- la figure 3 est une vue schématique qui illustre l'agencement, sous forme de digits à 7 segments, des points d'émission lumineux fournis par la cellule d'affichage émissive.

### Description détaillée d'un mode de réalisation de l'invention

La présente invention procède de l'idée générale inventive qui consiste à procurer un dispositif d'affichage digital qui, à l'aide des moyens techniques disponibles actuellement, permet de reproduire l'aspect et le mode de fonctionnement des premiers dispositifs d'affichage digitaux apparus au Japon au début des années 1970. Ce dispositif d'affichage digital qui se compose d'une cellule d'affichage à cristal liquide transflective disposée au-dessus d'une cellule d'affichage émissive est plus fiable et plus économique que les premiers dispositifs d'affichage digitaux et permet en outre d'afficher en permanence les informations utiles tout en réalisant des gains substantiels en termes de consommation électrique. La présente invention concerne également une pièce d'horlogerie, en particulier une montre-bracelet, équipée du présent dispositif d'affichage digital.

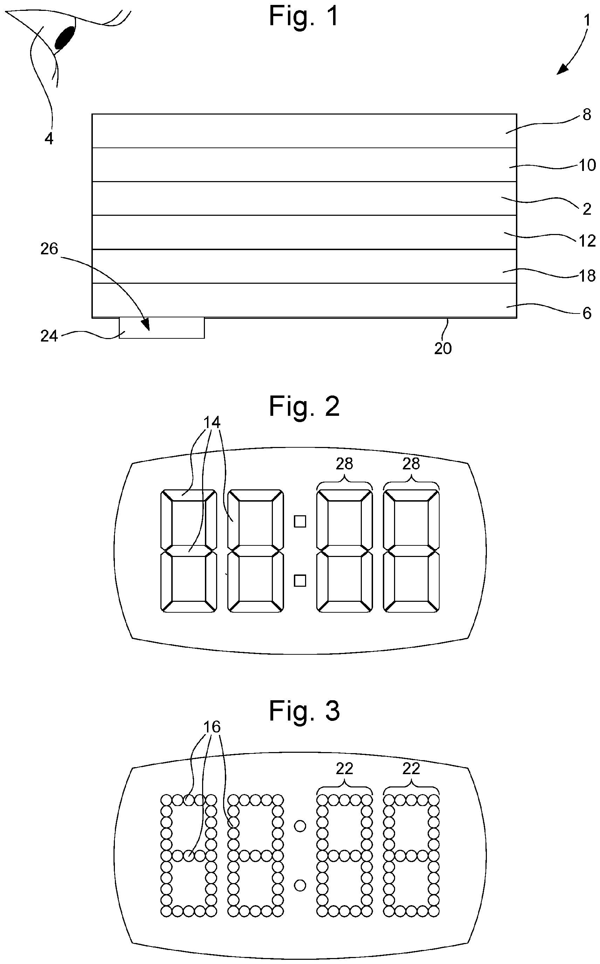

La figure 1 est une vue schématique en coupe d'un dispositif d'affichage digital conforme à l'invention. Désigné dans son ensemble par la référence numérique générale 1, ce dispositif d'affichage digital comprend une cellule d'affichage à cristal liquide transflective 2 disposée, par rapport à un observateur 4, au-dessus d'une cellule d'affichage émissive 6.

Le dispositif d'affichage digital 1 est complété par un premier filtre rouge 8 qui, disposé au-dessus de la cellule d'affichage à cristal liquide transflective 2, du côté par lequel la lumière ambiante pénètre dans ce dispositif d'affichage digital 1, permet d'impartir aux informations affichées par cette cellule d'affichage à cristal liquide transflective 2 une couleur rouge semblable à celle dans laquelle s'affichaient les informations fournies par les premiers dispositifs d'affichage digitaux apparus sur le marché au début des années 1970.

A titre d'exemple préféré mais non limitatif, la cellule d'affichage à cristal liquide transflective 2 est du type nématique en hélice, également connue sous sa dénomination anglo-saxonne Twisted Nematic cell ou cellule TN. Pour son bon fonctionnement, une telle cellule d'affichage à cristal liquide nématique en hélice TN requiert conventionnellement un polariseur linéaire 10 et un polariseur transflectif 12. Le polariseur linéaire 10 est disposé au-dessus de la cellule d'affichage à cristal liquide TN, c'est-à-dire du côté par lequel la lumière ambiante pénètre dans cette dernière, tandis que le polariseur transflectif 12 est disposé sous cette cellule d'affichage à cristal liquide TN. Comme on le comprendra mieux à la lecture de ce qui va suivre, la cellule d'affichage à cristal liquide TN affiche les informations au moyen d'électrodes conformées en segments 14 qui sont agencés de façon à former des digits à 7 segments.

En ce qui concerne la cellule d'affichage émissive 6, il s'agit, préférentiellement mais non limitativement, d'une cellule d'affichage à diodes électroluminescentes organiques, ces diodes étant encore connues sous leur dénomination anglo-saxonne Organic Light Emitting Diode ou OLED. Pour l'affichage des informations, une telle cellule d'affichage OLED fournit une pluralité de points lumineux 16 juxtaposés.

Le dispositif d'affichage digital 1 comprend enfin un second filtre rouge 18 disposé entre le polariseur transflectif 12 et la cellule d'affichage OLED. L'ajout de ce second filtre rouge 18 présente un double intérêt : tout d'abord, il permet, si nécessaire, de corriger le spectre d'émission de la lumière fournie par la cellule d'affichage OLED afin d'obtenir la couleur souhaitée, rouge dans le cas présent ; ensuite, il permet que les informations affichées par le dispositif d'affichage digital 1 selon l'invention se détachent sur un fond noir, tout en évitant de devoir recourir à des solutions complexes, coûteuses et encombrantes faisant intervenir des polariseurs circulaires ou autres composants optiques.

Dans l'exemple représenté à la figure 1, le premier filtre rouge 8 et le polariseur linéaire 10 sont disposés dans cet ordre au-dessus de la cellule d'affichage à cristal liquide transflective 2. On notera cependant que selon un mode particulier d'exécution de l'invention, cet ordre peut être inversé, le premier filtre rouge 8 étant disposé entre le polariseur linéaire 10 et la cellule d'affichage à cristal liquide transflective 2. Ce premier filtre rouge 8 peut aussi être disposé entre la cellule d'affichage à cristal liquide transflective 2 et le polariseur transflectif 12. Le premier filtre rouge 8 permet d'impartir une couleur rouge aux informations affichées par la cellule d'affichage à cristal liquide transflective 2. Ce premier filtre rouge 8 peut être réalisé au moyen d'un film teinté en rouge dans la masse ou bien au moyen d'un film transparent revêtu d'une couche d'encre rouge sur l'une au moins de ses deux faces. Ce premier filtre rouge 8 peut aussi être formé par un polariseur rouge.

Le polariseur linéaire 10, nécessaire au fonctionnement de la cellule d'affichage à cristal liquide TN, détermine également le contraste négatif (clair sur fond sombre) ou positif (sombre sur fond clair) avec lequel les informations fournies par cette cellule d'affichage à cristal liquide TN s'affichent. Dans le cas présent, le polariseur linéaire 10 est orienté de façon que la cellule d'affichage à cristal liquide TN soit du type à contraste négatif et que les informations qu'elle affiche apparaissent en rouge sur un fond noir.

La cellule d'affichage à cristal liquide TN comprend notamment deux substrats qui s'étendent parallèlement à et à distance l'un de l'autre et qui sont réunis entre eux par un cadre de scellement, de façon à délimiter une enceinte étanche pour le confinement du cristal liquide nématique en hélice. Ces substrats sont minces, typiquement de l'ordre de quelques dixièmes de millimètre, afin de limiter le phénomène de parallaxe, ce qui permet d'améliorer la réflectivité de la cellule d'affichage à cristal liquide TN et la lisibilité des informations affichées par cette dernière.

Lorsque la cellule d'affichage à cristal liquide transflective 2 est activée et qu'elle affiche des informations, le polariseur transflectif 12 disposé sous la cellule d'affichage à cristal liquide transflective 2 renvoie la lumière ambiante qui pénètre par le haut dans le dispositif d'affichage digital 1 et permet à l'observateur 4 de lire ces informations. Lorsque la cellule d'affichage à cristal liquide transflective 2 est à l'état passif, elle n'affiche aucune information et laisse passer la lumière produite par la cellule d'affichage émissive 6. A ce moment-là, la cellule d'affichage à cristal liquide transflective 2 est transparente.

L'application d'un champ électrique entre une électrode et une contre-électrode correspondante (non visible au dessin), permet à la cellule d'affichage à cristal liquide TN d'afficher des informations. Ces électrodes sont structurées en segments 14 agencés de façon à former des premiers digits à 7 segments 28. Combinés avec le premier filtre rouge 8, ces digits à 7 segments 28 permettent de reproduire à l'identique l'aspect des informations telles qu'affichées par les premiers dispositifs d'affichage digitaux apparus au début des années 1970. La cellule d'affichage à cristal liquide TN utilisée dans le cadre de la présente invention est néanmoins supérieure au dispositif d'affichage digital à diodes électroluminescentes rouges utilisé dans les premières montres digitales : en effet, alors que ces premiers dispositifs d'affichage digitaux à LEDs étaient gros consommateurs d'énergie électrique et ne pouvaient donc être activés que de manière ponctuelle, lorsque le porteur de la montre voulait consulter l'heure, les cellules d'affichage à cristal liquide TN consomment très peu de courant électrique et peuvent donc être maintenues activées en permanence.

En ce qui concerne la cellule d'affichage OLED, celle-ci fournit (voir figure 3) une pluralité de points lumineux 16 qui sont juxtaposés de manière à former des seconds digits 22 à 7 segments qui sont chacun formé par exemple de cinq points lumineux 16. Selon l'invention, la cellule d'affichage à cristal liquide transflective 2 fournit des informations en permanence. Cependant, lorsque les conditions d'éclairement ambiant ne sont pas suffisantes pour permettre au porteur de la montre de lire l'information fournie par la cellule d'affichage à cristal liquide transflective 2, le porteur de la montre peut appuyer sur un bouton-poussoir, ce qui provoque l'arrêt de la cellule d'affichage à cristal liquide transflective 2, et l'allumage momentané de la cellule d'affichage émissive 6. Après un laps de temps durant lequel la cellule d'affichage émissive 6 est allumée et le porteur de la montre peut lire les informations affichées par cette cellule d'affichage émissive 6, cette dernière s'éteint à nouveau et la cellule d'affichage à cristal liquide transflective 2 est à nouveau activée. On notera que grâce aux techniques utilisées pour fabriquer les cellules d'affichage OLED, il est possible de créer des points lumineux de manière extrêmement précise et homogène. En effet, résumé de manière très succincte, une cellule d'affichage OLED comprend une série de films minces organiques pris en sandwich entre deux électrodes en film mince conductrices de l'électricité (anode et cathode). Lorsqu'un courant électrique est appliqué à une cellule d'affichage OLED, il se crée un champ électrique sous l'effet duquel les porteurs de charges, électrons et trous, migrent depuis les électrodes dans les films minces organiques jusqu'à ce qu'ils se recombinent en formant des excitons, c'est-à-dire des paires électron-trou liées par les forces de Coulomb. Une fois formés, ces excitons, ou états excités, se relaxent vers un niveau d'énergie moindre en émettant des photons. Par dépôt sélectif d'une couche de passivation transparente et électriquement isolante entre l'anode et la cathode, il est possible de structurer très finement les surfaces par lesquelles la cellule d'affichage OLED émet de la lumière.

Selon un mode préféré mais non limitatif d'exécution de l'invention, on équipe le dispositif d'affichage digital 1 d'un capteur de lumière 24 afin d'ajuster l'intensité de la cellule d'affichage OLED en fonction des conditions d'éclairement ambiant. Plus précisément, on prévoit de réduire d'autant plus l'intensité de la lumière produite par la cellule d'affichage OLED que l'éclairement ambiant est faible. Ceci est particulièrement avantageux pour un utilisateur qui veut consulter sa montre durant la nuit et qui ne sera pas ébloui par une intensité lumineuse trop forte produite par la cellule d'affichage OLED. A cet effet, le capteur de lumière 24 est placé sous la cellule d'affichage émissive 6, autrement dit sous la cellule d'affichage OLED, et on ménage une ouverture 26 dans la cathode 20 de cette dernière afin que la lumière ambiante qui pénètre par le haut dans le dispositif d'affichage digital 1 selon l'invention puisse parvenir jusqu'au capteur de lumière 24. En effet, la cathode 28 étant métallique, elle est totalement opaque.

Enfin, du point de vue électronique, chacune des deux cellules d'affichage 2 et 6 possède son propre driver. Un microcontrôleur gère les deux drivers indépendamment l'un de l'autre en fonction du choix de l'utilisateur qui a appuyé ou pas sur le bouton-poussoir de la montre pour activer la cellule d'affichage émissive et du signal représentatif du degré d'éclairement ambiant envoyé par le capteur de lumière.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées. On comprend notamment que le présent dispositif d'affichage digital 1 selon l'invention est destiné à être embarqué dans une pièce d'horlogerie, en particulier une montre-bracelet. On prendra également bonne note que, dans la présente description, lorsqu'il est mentionné qu'un premier composant, par exemple le premier filtre rouge, est disposé au-dessus d'un second composant, par exemple la cellule d'affichage à cristal liquide transflective, cela précise uniquement l'ordre dans lequel ces premier et second composants se succèdent du haut vers le bas de l'empilement de composants qui constituent le dispositif d'affichage digital selon l'invention, mais ne signifie en aucun cas que le second composant suit immédiatement le premier composant dans cet empilement ; il est tout à fait possible qu'un ou plusieurs composants supplémentaires soient disposés entre le premier et le second composant. On comprendra également que par cellule d'affichage à cristal liquide transflective activée, on entend qu'un champ électrique est appliqué entre électrode et contre-électrode de cette cellule d'affichage à cristal liquide transflective, ce qui permet à cette dernière d'afficher des informations. Inversement, lorsque la cellule d'affichage à cristal liquide transflective est dite à l'état passif ou inactivée, cela signifie qu'aucun champ électrique n'est appliqué entre électrode et contre-électrode de cette cellule d'affichage à cristal liquide transflective et que celle-ci n'affiche donc aucune information. Enfin, on notera que par polariseur transflectif, on entend un polariseur qui se comporte de manière transflective lorsque la cellule à cristal est activée et affiche des informations, et qui est transparent par rapport à la lumière émise par la cellule d'affichage OLED lorsque celle-ci est activée. Par conséquent, ce polariseur transflectif impartit à la cellule d'affichage à cristal liquide un comportement également transflectif : lorsque cette cellule d'affichage à cristal liquide est activée et qu'elle affiche des informations, elle se comporte de manière transflective vis-à-vis de la lumière ambiante qui pénètre dans le dispositif d'affichage digital, et lorsque la cellule d'affichage à cristal liquide est inactivée, c'est-à-dire lorsqu'elle n'affiche aucune information, elle est transparente vis-à-vis de la lumière produite par la cellule d'affichage OLED qui est activée.

### Nomenclature

1. Dispositif d'affichage digital
2. Cellule d'affichage à cristal liquide transflective
4. Observateur
6. Cellule d'affichage transflective
8. Premier filtre rouge
10. Polariseur linéaire
12. Polariseur transflectif
14. Segments
16. Points lumineux
18. Second filtre rouge
20. Premiers digit à 7 segments
22. Seconds digits à 7 segments
24. Capteur de lumière
26. Ouverture
28. Cathode

## Revendications

1. Dispositif d'affichage digital comprenant, du haut vers le bas, un premier filtre rouge (8), une cellule d'affichage à cristal liquide transflective (2), un second filtre rouge (18) et une cellule d'affichage émissive (6), la cellule d'affichage à cristal liquide transflective (2) affichant des informations au moyen d'au moins un premier digit à sept segments (20) et la cellule d'affichage émissive comprenant une pluralité de points lumineux (16) juxtaposés qui sont agencés de façon à afficher au moins un second digit (22) à sept segments.

2. Dispositif d'affichage digital selon la revendication 1, **caractérisé en ce que** la cellule d'affichage à cristal liquide transflective (2) est une cellule d'affichage à cristal liquide nématique en hélice, également connue sous sa dénomination anglo-saxonne Twisted Nematic Liquid Crystal Display Device ou cellule TN, à laquelle sont associés un polariseur linéaire (10) disposé au-dessus de la cellule d'affichage à cristal liquide nématique en hélice et un polariseur transflectif (12) disposé en-dessous de la cellule d'affichage à cristal liquide nématique.

3. Dispositif d'affichage digital selon la revendication 2, **caractérisé en ce que** la cellule d'affichage émissive (6) est une cellule d'affichage à diodes électroluminescentes organiques, également connues sous leur dénomination anglo-saxonne Organic Light-Emitting Diode, qui émettent une lumière rouge.

4. Dispositif d'affichage digital selon la revendication 3, **caractérisé en ce qu'**il comprend, de haut en bas et dans cet ordre :
• le premier filtre rouge (8) ;
• le polariseur linéaire (10) ;
• la cellule d'affichage à cristal liquide nématique en hélice ;
• le polariseur transflectif (12) ;
• le second filtre rouge (18) ;
• la cellule d'affichage à diodes électroluminescentes organiques.

5. Dispositif d'affichage digital selon la revendication 3, **caractérisé en ce qu'**il comprend, de haut en bas et dans cet ordre :
• le polariseur linéaire (10) ;
• le premier filtre rouge (8) ;
• la cellule d'affichage à cristal liquide nématique en hélice ;
• le polariseur transflectif (12) ;
• le second filtre rouge (18) ;
• la cellule d'affichage à diodes électroluminescentes organiques.

6. Dispositif d'affichage digital selon l'une des revendications 1 à 5, **caractérisé en ce qu'**il comprend un capteur de lumière (24) qui, placé sous la cellule d'affichage émissive (6), mesure l'intensité de la lumière ambiante, cette mesure de l'intensité de la lumière ambiante étant utilisée pour accommoder la luminosité de la cellule d'affichage émissive (6) en fonction des conditions d'éclairement ambiant.

## Patentansprüche

1. Digitale Anzeigevorrichtung, umfassend, von oben nach unten, einen ersten Rotfilter (8), eine transflektive Flüssigkristallanzeigezelle (2), einen zweiten Rotfilter (18) und eine emissive Anzeigezelle (6), wobei die transflektive Flüssigkristallanzeigezelle (2) Informationen mittels mindestens eines ersten Digits mit sieben Segmenten (20) anzeigt und die emissive Anzeigezelle eine Vielzahl von nebeneinanderliegenden Lichtpunkten (16) umfasst, die derart eingerichtet sind, dass mindestens ein zweites Digit (22) mit sieben Segmenten angezeigt wird.

2. Digitale Anzeigevorrichtung nach Anspruch 1, **dadurch gekennzeichnet, dass** die transflektive Flüssigkristallanzeigezelle (2) eine verdrillt-nematische Flüssigkristallanzeigezelle, ebenfalls unter ihrer angelsächsischen Bezeichnung Twisted Nematic Liquid Crystal Display Device oder TN-Zelle bekannt, ist, der ein Linearpolarisator (10), der über der verdrillt-nematischen Flüssigkristallanzeigezelle angeordnet ist, und ein transflektiver Polarisator (12), der unter der nematischen Flüssigkristallanzeigezelle angeordnet ist, zugeordnet sind.

3. Digitale Anzeigevorrichtung nach Anspruch 2, **dadurch gekennzeichnet, dass** die emissive Anzeigezelle (6) eine Anzeigezelle mit organischen elektrolumineszierenden Dioden, ebenfalls bekannt unter ihrer angelsächsischen Bezeichnung Organic Light-Emitting Diode, ist, die ein rotes Licht emittieren.

4. Digitale Anzeigevorrichtung nach Anspruch 3, **dadurch gekennzeichnet, dass** sie von oben nach unten und in dieser Reihenfolge umfasst:
• den ersten Rotfilter (8);
• den Linearpolarisator (10);
• die verdrillt-nematische Flüssigkristallanzeigezelle;
• den transflektiven Polarisator (12);
• den zweiten Rotfilter (18);
• die Anzeigezelle mit organischen elektrolumineszierenden Dioden.

5. Digitale Anzeigevorrichtung nach Anspruch 3, **dadurch gekennzeichnet, dass** sie von oben nach unten und in dieser Reihenfolge umfasst:
• den Linearpolarisator (10);
• den ersten Rotfilter (8);
• die verdrillt-nematische Flüssigkristallanzeigezelle;
• den transflektiven Polarisator (12);
• den zweiten Rotfilter (18);
• die Anzeigezelle mit organischen elektrolumineszierenden Dioden.

6. Digitale Anzeigevorrichtung nach einem der Ansprüche 1 bis 5, **dadurch gekennzeichnet, dass** sie einen Lichtsensor (24) umfasst, der, unter der emissiven Anzeigezelle (6) platziert, die Stärke des Umgebungslichts misst, wobei diese Messung des Umgebungslichts verwendet wird, um die Lichtstärke der emissive Anzeigezelle (6) in Abhängigkeit von den umgebenden Beleuchtungsbedingungen anzupassen.

## Claims

1. A digital display device comprising, from top to bottom, a first red filter (8), a transflective liquid crystal display cell (2), a second red filter (18) and an emissive display cell (6), the transflective liquid crystal display cell (2) displaying information by means of at least one first seven-segment digit (20) and the emissive display cell comprising a plurality of juxtaposed light points (16) which are arranged so as to display at least one second seven-segment digit (22).

2. The digital display device according to claim 1, **characterised in that** the transflective liquid crystal display cell (2) is a Twisted Nematic Liquid Crystal Display cell, also known as Twisted Nematic Liquid Crystal Display Device or TN cell, with which are associated a linear polariser (10) disposed above the twisted nematic liquid crystal display cell and a transflective polariser (12) disposed below the nematic liquid crystal display cell.

3. The digital display device according to claim 2, **characterised in that** the emissive display cell (6) is an Organic Light-Emitting Diode display cell which emits a red light.

4. The digital display device according to claim 3, **characterised in that** it comprises, from top to bottom and in this order:
• the first red filter (8) ;
• the linear polariser (10) ;
• the twisted nematic liquid crystal display cell;
• the transflective polariser (12) ;
• the second red filter (18) ;
• the organic light-emitting diode display cell.

5. The digital display device according to claim 3, **characterised in that** it comprises, from top to bottom and in this order:
• the linear polariser (10) ;
• the first red filter (8) ;
• the twisted nematic liquid crystal display cell;
• the transflective polariser (12) ;
• the second red filter (18) ;
• the organic light-emitting diode display cell.

6. The digital display device according to one of claims 1 to 5, **characterised in that** it comprises a light sensor (24) which, placed under the emissive display cell (6), measures the intensity of the ambient light, this measurement of the intensity of the ambient light being used to accommodate the luminosity of the emissive display cell (6) depending on the ambient illumination conditions.
